(19) **Europäisches Patentamt**
**European Patent Office**
**Office européen des brevets**

(11) **EP 2 249 358 A1**

(12) **EUROPEAN PATENT APPLICATION**
published in accordance with Art. 153(4) EPC

(43) Date of publication:
**10.11.2010 Bulletin 2010/45**

(21) Application number: **09714593.2**

(22) Date of filing: **12.02.2009**

(51) Int Cl.:
*H01G 7/06* *(2006.01)*

(86) International application number:
**PCT/JP2009/052332**

(87) International publication number:
**WO 2009/107489 (03.09.2009 Gazette 2009/36)**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **29.02.2008 JP 2008051364**

(71) Applicant: **Sony Corporation
Tokyo 108-0075 (JP)**

(72) Inventors:
• **KANNO, Masayoshi
Tokyo 108-0075 (JP)**
• **HABU, Kazutaka
Tokyo 108-0075 (JP)**
• **WATANABE, Makoto
Tokyo 108-0075 (JP)**
• **YOKOTA, Toshiaki
Tokyo 108-0075 (JP)**

(74) Representative: **Jackson, Jonathan Andrew
D Young & Co LLP
120 Holborn
London EC1N 2DY (GB)**

(54) **VARIABLE-CAPACITANCE ELEMENT, METHOD FOR ADJUSTING VARIABLE-CAPACITANCE ELEMENT, VARIABLE-CAPACITANCE DEVICE AND ELECTRONIC APPARATUS**

(57) A variable-capacitance element the capacitance value of which can be freely set to a desired value corresponding to a write voltage, and, once set, is maintained also after the write voltage is removed. The invention also provides a method for adjusting a variable-capacitance element, a variable-capacitance device and an electronic apparatus.

According to the invention, a variable-capacitance element 100 includes a pair of electrodes 101 and 102 formed with a ferroelectric material layer 103 in between. The variable-capacitance element is adjusted by the steps of: maximizing or minimizing the sum of electric dipole moments of the ferroelectric material layer 103; and writing a desired capacitance to the variable-capacitance element 100 by applying a desired write voltage V between the electrodes 101 and 102 of the variable-capacitance element 100 the sum of electric dipole moments of the ferroelectric material layer 103 of which has been maximized or minimized.

[FIG. 1]

EP 2 249 358 A1

**Description**

Technical Field

The present invention relates to a non-volatile variable-capacitance element the capacitance of which varies with a given write voltage and is maintained also after the write voltage is removed. The present invention also relates to a method for adjusting the variable-capacitance element, a variable-capacitance device and an electronic apparatus.

Background Art

Conventionally, in order to control frequency, time or the like, a variable-capacitance diode (varicap), a MEMS and the like have been commercialized and widely used. These elements allow only a small current (microampere-level current) to flow and are not applicable to high power application. However, the inventors have proposed a variable-capacitance element including a ferroelectric material allowing a large current to flow.

For example, Patent Document 1 below describes a variable capacitor having a electrode structure that improves reliability and productivity, in which barium titanate system is used as a high dielectric material.

Any of these conventional variable-capacitance elements is a variable-capacitance element the terminal capacitance of which varies with an applied control voltage, and is, so to speak, a volatile variable-capacitance element the capacitance of which returns to the original value when the control voltage is removed. Therefore, such a volatile variable-capacitance element needs to be continuously controlled. Accordingly, an electronic apparatus including this variable-capacitance element needs a control circuit and a power source for controlling the variable-capacitance element.

Patent Document 1: JP-A-2007-287996

Disclosure of the Invention

Problems to be Solved by the Invention

Also, an electronic apparatus not always capable of being controlled may need to have a tuning frequency shift due to component-to-component variations or the like corrected using a variable-capacitance element in factory setting. However, the conventional variable-capacitance elements, which are volatile and need to be continuously controlled, cannot meet those needs.

In view of the above, the invention provides a variable-capacitance element the capacitance of which can be freely set to a desired value corresponding to a write voltage, and, once set, is maintained also after the write voltage is removed. The invention also provides a method for adjusting the variable-capacitance element, a variable-capacitance device and an electronic apparatus.

Means for Solving the Problems

In order to solve the above problem and achieve an object of the invention, a variable-capacitance element in accordance with the invention is characterized by including a plurality of unit variable-capacitance elements connected in series or parallel, each of the unit variable-capacitance elements including a pair of electrodes formed with a ferroelectric material layer in between.

The capacitance of variable-capacitance element in accordance with the invention is varied by applying a dc voltage, and the varied capacitance is maintained after the dc voltage is removed.

A method for adjusting a variable-capacitance element, the variable-capacitance element including a pair of electrodes formed with a ferroelectric material layer in between, includes the steps of: maximizing or minimizing the sum of electric dipole moments of the ferroelectric material layer; and writing a desired capacitance to the variable-capacitance element by applying a desired write voltage between the electrodes of the variable-capacitance element the sum of electric dipole moments of the ferroelectric material layer of which has been maximized or minimized.

According to the invention, the write voltage is a dc voltage applied to the variable-capacitance element for writing a desired capacitance to the variable-capacitance element. According to the method for adjusting a variable-capacitance element in accordance with the invention, the variable-capacitance element is adjusted so as to have a desired capacitance. Also, the method includes the step of maximizing or minimizing the sum of electric dipole moments of the ferroelectric material layer, which can widen the adjustable range of the capacitance.

A variable-capacitance device in accordance with the invention is characterized by including: a variable-capacitance element including a pair of electrodes formed with a ferroelectric material layer in between; and capacitance elements for eliminating dc voltage disposed on both sides of the variable-capacitance element and connected to the variable-capacitance element in series.

The variable-capacitance device is characterized by further including: a variable-capacitance element including a plurality of unit variable-capacitance elements connected in series or parallel, each of the unit variable-capacitance elements including a pair of electrodes formed with a ferroelectric material layer in between; and capacitance elements for eliminating dc voltage disposed on both sides of the variable-capacitance element and connected to the variable-capacitance element in series.

The variable-capacitance device in accordance with the invention includes the capacitance elements for eliminating dc voltage. So, when the variable-capacitance device is built into a given circuit, the dc voltage externally applied to the variable-capacitance element can be prevented from influencing the circuit.

An electronic apparatus in accordance with the invention is characterized by including a variable-capacitance device that includes: a variable-capacitance element including a pair of electrodes formed with a ferroelectric material layer in between; and capacitance elements for eliminating dc voltage disposed on both sides of the variable-capacitance element and connected to the variable-capacitance element in series.

Also the electronic apparatus is characterized by including a variable-capacitance device that includes: a variable-capacitance element including a plurality of unit variable-capacitance elements connected in series or parallel, each of the unit variable-capacitance elements including a pair of electrodes formed with a ferroelectric material layer in between; and capacitance elements for eliminating dc voltage disposed on both sides of the variable-capacitance element and connected to the variable-capacitance element in series.

The electronic apparatus in accordance with the invention includes the variable-capacitance device including the capacitance elements for eliminating dc voltage, so a dc voltage can be externally applied to the variable-capacitance element without influencing the electronic apparatus. Also, the capacitance of the variable-capacitance element is adjusted by externally applying a dc voltage.


Advantage of the Invention

According to the variable-capacitance element in accordance with the invention, the capacitance of the variable-capacitance element can be precisely adjusted by applying a dc voltage to the variable-capacitance element.

According to the method for adjusting a variable-capacitance element in accordance with the invention, the adjustable range of the capacitance of the variable-capacitance element can be widened.

According to the variable-capacitance device in accordance with the invention, the capacitance of the variable-capacitance element can be adjusted when the variable-capacitance device is implemented in a desired electronic apparatus.

According to the electronic apparatus in accordance with the invention, the capacitance of the variable-capacitance element in the variable-capacitance device can be adjusted, so electronic apparatus-to-electronic apparatus variations or shift in tuning frequency can be corrected.


Brief Description of the Drawings

[Fig. 1] A schematic diagram of a variable-capacitance element used in a method for adjusting the variable-capacitance element in accordance with one embodiment of the invention.

[Fig. 2] A chart showing how the capacitance of the variable-capacitance element varies with the write voltage.

[Fig. 3] A schematic diagram showing a hysteresis curve of a ferroelectric material.

[Fig. 4] A chart showing how the capacitance of the variable-capacitance element varies with the write voltage.

[Fig. 5] A chart showing how the capacitance of the variable-capacitance element varies with the write voltage.

[Fig. 6] A circuit diagram of the variable-capacitance element in accordance with a first embodiment of the invention.

[Fig. 7] A schematic diagram showing how the capacitance of the variable-capacitance element in accordance with the first embodiment of the invention varies with the write voltage.

[Fig. 8] A chart showing how the capacitance of a variable-capacitance element including unit variable-capacitance elements connected in series varies with the write voltage, and how the capacitance of one unit variable-capacitance element varies with the write voltage.

[Fig. 9] A chart showing how the capacitance of a variable-capacitance element including seven unit variable-capacitance elements connected in series varies with the write voltage, and how the voltage applied across the unit variable-capacitance element 1c is varied.

[Fig. 10A, 10B, 10C] Schematic views showing a specific example of configuration of a variable-capacitance element in accordance with the first embodiment of the invention (First) .

[Fig. 11] A schematic view showing a specific configuration of a variable-capacitance element in accordance with the first embodiment of the invention (Second).

[Fig. 12A, 12B, 12C] Schematic views showing a specific example of configuration of a variable-capacitance element in accordance with the first embodiment of the invention (Third) .

[Fig. 13] A schematic view showing a specific configuration of a variable-capacitance element in accordance with the first embodiment of the invention (Fourth).

[Fig. 14] A circuit diagram of a variable-capacitance element in accordance with a second embodiment of the invention.

[Fig. 15] A schematic diagram showing how the capacitance of the variable-capacitance element in accordance with the second embodiment of the invention varies with the write voltage.

[Fig. 16A, 16B, 16C] Schematic views showing a specific example of configuration of a variable-capacitance element in accordance with the second embodiment of the invention (First) .

[Fig. 17] A schematic view showing a specific configuration of a variable-capacitance element in accordance with the second embodiment of the invention (Second).

[Fig. 18] A circuit diagram of an example of a variable-capacitance device in accordance with the invention.

[Fig. 19] A circuit diagram of an example of an electronic apparatus including the variable-capacitance device in accordance with the invention.

Description of Reference Numerals and Signs

| 1 | variable-capacitance element |
|---|---|
| 1c | unit variable-capacitance element |
| 2 | write voltage source |
| 2c | unit variable-capacitance element |
| 3c | unit variable-capacitance element |
| 4 | variable-capacitance element |
| 4c | unit variable-capacitance element |
| 5a | first external electrode |
| 5b | second external electrode |
| 6 | terminal |
| 7 | terminal |
| 8 | ferroelectric layer |
| 10 | variable-capacitance element |
| 11 | variable-capacitance element |
| 12 | variable-capacitance element |
| 13 | variable-capacitance element |
| 14 | variable-capacitance element |
| 15 | variable-capacitance element |
| 40 | step-up transformer |
| 41 | drive circuit |
| 42 | CCFL |
| 43 | capacitance element |
| 44 | variable-capacitance element |
| 46 | dc voltage source |
| 47 | external input terminal |
| 49 | variable-capacitance device |
| 50 | variable-capacitance element |
| 51 | unit variable-capacitance element |
| 52 | unit variable-capacitance element |
| 100 | variable-capacitance element |
| 101 | electrode |
| 103 | ferroelectric material layer |
| e1 | in-plane electrode |
| e2 | in-plane electrode |
| e3 | in-plane electrode |
| e4 | in-plane electrode |
| e5 | in-plane electrode |

Mode for Carrying Out the Invention

A variable-capacitance element in accordance with the invention is a writable variable-capacitance element the capacitance of which is rewritable, and also a non-volatile variable-capacitance element the capacitance once written of which can be maintained also when no voltage is applied. As described later, when a variable-capacitance device including the variable-capacitance element in accordance with the invention is built into an electronic apparatus, the capacitance of the variable-capacitance element can be corrected also after the electronic apparatus is completed.
An embodiment of the invention is described below with reference to the drawings.

[Method for adjusting a variable-capacitance element]

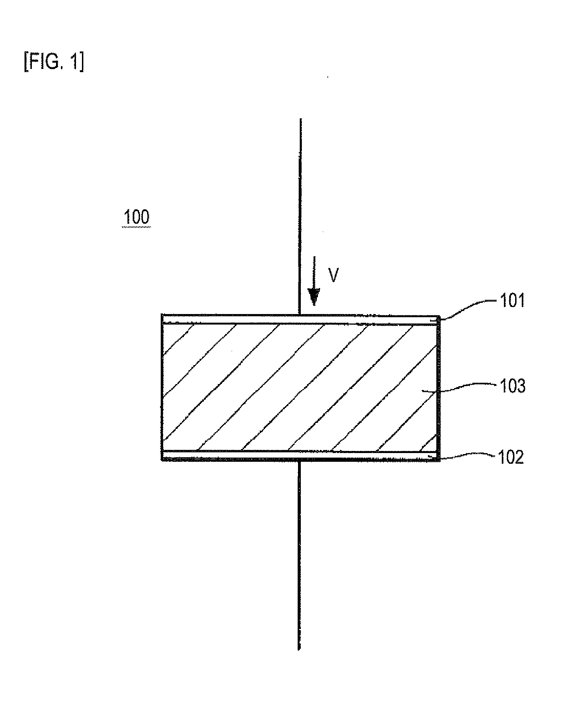

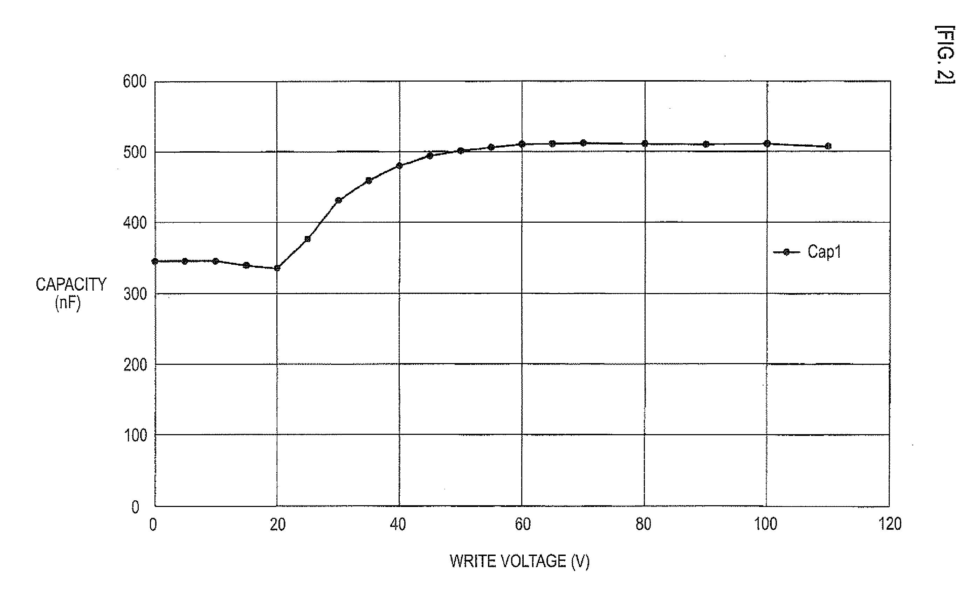

First, a method for adjusting a variable-capacitance element in accordance with the invention is described. Fig. 1 shows a schematic configuration of a variable-capacitance element used in one embodiment according to the method for adjusting the variable-capacitance element in accordance with the invention. A variable-capacitance element 100 shown in Fig. 1 includes a ferroelectric material layer 103 and a pair of electrodes 101 and 102 with the ferroelectric material layer 103 in between. A write voltage V (dc voltage) is applied between the electrodes 101 and 102. The ferroelectric material layer 103 of the variable-capacitance element 100 shown in Fig. 1 is made of PZT (lead zirconium titanate), for example.
A method for adjusting a variable-capacitance element 100 shown in Fig. 1 is described with reference to Figs. 2 through 5.
Fig. 2 shows how the capacitance written to the variable-capacitance element 100 shown in Fig. 1 varied with the write voltage V applied between the electrodes 101 and 102 of the variable-capacitance element 100. In Fig.2, the horizontal axis indicates the write voltage V, and the vertical axis indicates the capacitance of the variable-capacitance element 100. A capacitance Cap1 shown in Fig. 2 indicates a capacitance measured after a corresponding write voltage V indicated by the horizontal axis was applied to and removed from the variable-capacitance element 100 (i.e., after the applied write voltage was returned to 0 V). In other words, the capacitance Cap1 was not a capacitance measured with the corresponding write voltage V applied, but was a capacitance measured after applying and removing the corresponding write voltage V at each measuring point.
In this example embodiment, first, the variable-capacitance element 100 was heated to a temperature equal to or higher than the Curie temperature before the start of the measurement of capacitances shown in Fig. 2. Accordingly, in Fig. 2, the capacitance Cap1 with a write voltage V of 0 V was a capacitance when electric dipole moments of the ferroelectric material layer 103 were minimized by heating the variable-capacitance element 100 to the temperature equal to or higher than the Curie temperature.
As seen from Fig. 2, while the write voltage V increased to 20 V, the capacitance Cap1 of the variable-capacitance element 100 exhibited almost no change, but slightly decreased. Then, when the write voltage V was 20 V, the capacitance Cap1 of the variable-capacitance element 100 was at its minimum. Further, as the write voltage V increased over 20 V, the capacitance Cap1 increased gently. Then, when the write voltage V was over 60 V, the capacitance Cap1 was almost constant. In this example embodiment, the maximum of the capacitance Cap1 was approximately 1.5 times larger than the minimum of the capacitance Cap1.
After the write voltage V is applied to and removed from the variable-capacitance element 100, the capacitance once written is maintained. Further, as seen from the variation in the capacitance Cap1 shown in Fig. 2, in the range of the write voltage V from 20 to 60 V, when a higher write voltage V than the previously applied write voltage V is applied, a larger capacitance than the previously written capacitance is rewritten. In other words, in the range of the write voltage V from 20 to 60 V, the capacitance is rewrote by applying a higher write voltage V than the previously applied write voltage V.
For example, as seen from Fig. 2, when a write voltage V of 30 V is applied to the variable-capacitance element 100, the capacitance is maintained at 435 pF and the variable-capacitance element 100 can be used as having a capacitance of 435 pF. Additionally, a write voltage V of 40 V is reapplied to the variable-capacitance element 100, the capacitance is maintained at 480 pF and the variable-capacitance element 100 can be used as having a capacitance of 480 pF. In this way, applying a desired write voltage V adjusts the capacitance of the variable-capacitance element 100 to allow the variable-capacitance element 100 to be used as having the adjusted capacitance.
Thus, the variable-capacitance element 100 can be used as having a capacitance Cap1 corresponding to the write voltage V. Further, a write voltage V higher than the write voltage V previously applied to the variable-capacitance element 100 within the range in which the capacitance Cap1 varies enables rewriting, or the rewriting of the capacitance, and allows the capacitance Cap1 of the variable-capacitance element 100 to be increased. As seen from Fig. 2, the range in which the capacitance Cap1 of the variable-capacitance element 100 varies is the range of the write voltage V from 20 to 60 V.
This variation in the capacitance Cap1 of the variable-capacitance element 100 is caused by the polarization reversal of the ferroelectric material layer 103, which is the variation in the sum of electric dipole moments. Then, as seen from Fig. 2, when a write voltage V is applied to the variable-capacitance element 100 in unpolarized state (when the sum of electric dipole moments is at its minimum), polarization happens in the ferroelectric material layer 103, causing the capacitance Cap1 to vary.

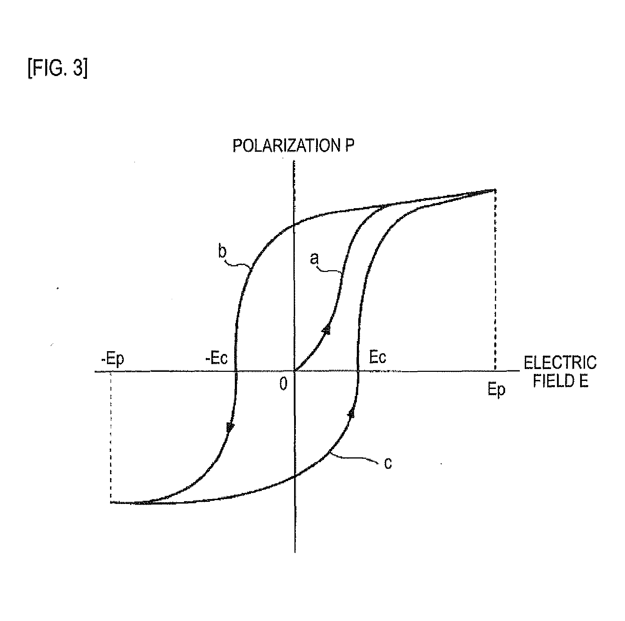

A property of a ferroelectric material is described with reference to Fig. 3 showing a hysteresis curve of the ferroelectric material. In the hysteresis curve shown in Fig. 3, the horizontal axis indicates the electric field E, and the vertical axis indicates the sum of electric dipole moments, or polarization P, of the ferroelectric material. In the ferroelectric material, the polarization P varies with the intensity of the electric field E as shown by the hysteresis curve in Fig. 3. First, consider the ferroelectric material with a polarization P of zero, meaning that the sum of electric dipole moments is at its minimum. Then, applying an positive voltage to the ferroelectric material to generate the increasing electric field E causes the polarization P to increase as shown by the curve a. When the electric field E reaches a certain value, the sum of electric dipole moments is at its maximum and the polarization P becomes saturated. The electric field E at this point is referred to as saturation electric field Ep. Then, applying an voltage to the ferroelectric material to decrease the electric field E causes the polarization P to decrease as shown by the curve b. When the electric field E reaches a certain value, the sum of electric dipole moments is at its minimum again and the polarization P becomes zero. The electric field E at this point is referred to as coercive electric field -Ec. Further generating the negative electric field E causes the sum of electric dipole moments to be at its maximum again and the polarization P to become saturated. The electric field E at this point is referred to as saturation electric field -Ep. Then, applying a voltage to the ferroelectric material to generate the increasing electric field E over the saturation electric field -Ep causes the polarization P to increase as shown by the curve c. When the electric field E reaches the coercive electric field Ec, the sum of electric dipole moments is at its minimum and the polarization P becomes zero. When the electric field E reaches the saturation electric field Ep, the polarization P becomes saturated again.

In the variation in the capacitance of the variable-capacitance element 100 shown in Fig. 2, the variable-capacitance element 100 was heated to a temperature equal to or higher than the Curie temperature before starting the measurement. Accordingly, the state of the variable-capacitance element 100 being heated to a temperature equal to or higher than the Curie temperature corresponds to the state with an electric field of zero and a polarization P of zero in the hysteresis curve shown in Fig. 3. The state of the increasing write voltage V being applied to the variable-capacitance element 100 shown in Fig. 2 corresponds to the variation in state shown by the curve a in the hysteresis curve in Fig. 3.

The write voltage V at which the capacitance Cap1 stops varying in Fig. 2 corresponds to the saturation electric field Ep in Fig. 3. Specifically, at the saturation electric field Ep, the sum of electric dipole moments (polarization P) of the ferroelectric material is at its maximum, and the capacitance of the variable-capacitance element 100 including the ferroelectric material layer 103 as shown in Fig. 1 becomes saturated at this point.

For varying the capacitance Cap1 of the variable-capacitance element 100 including the ferroelectric material layer 103, the practically important value is not the value of the write voltage V, but the value of the electric field E generated between the electrodes 101 and 102. In Fig. 2, a write voltage V of 10 V corresponds to an electric field of 0.02 V/$\mu$m. Then, in Fig. 2, applying a write voltage V to the variable-capacitance element 100 generates an electric field E corresponding to the write voltage V, causing polarization in the ferroelectric material layer 103 to vary the capacitance.

How the capacitance increases versus the electric field E almost depends on the electric susceptibility of the ferroelectric material. Then, as seen from Fig. 2, the variable-capacitance element 100 including the ferroelectric material layer 103 as shown in Fig. 1 is a non-volatile variable-capacitance element in which the capacitance written when a write voltage V is applied is maintained even after the voltage is set to 0 V.

In this example embodiment, the variable-capacitance element 100 in which PZT (lead zirconium titanate) was used as the ferroelectric material was used. However, in addition, an ion polarization ferroelectric material and an electron polarization ferroelectric material may be used.

The ion polarization ferroelectric material includes an ionic crystal material and is electrically polarized by the displacement of positive and negative ions. For example, the ion polarization ferroelectric materials are expressed by the chemical formula $ABO_3$ including an atom A and an atom B, have a perovskite structure, and include barium titanate, $KNbO_3$ and $ObTiO_3$. PZT (lead zirconium titanate), which was used in this example embodiment, is a ferroelectric material prepared by mixing lead zirconate ($PbZrO_3$) into lead titanate ($PbTiO_3$).

The electron polarization ferroelectric material is polarized by electric dipole moments generated by the separation of positively-charged and negatively-charged portions. Recently, a rare-earth iron oxide has been reported that exhibit a ferroelectric property caused by forming polarization through the formation of a $Fe^{2+}$ charge plane and a $Fe^{3+}$ charge plane. It has been reported that, in this series, a compound expressed by the molecular formula $(RE)-(TM)_2-O_4$ including rare earth metal (RE) and iron group transition metal (TM) has a high dielectric constant. For example, REs include Y, Er, Yb and Lu (Y and heavy rare earth metal element, among others), and TMs include Fe, Co and Ni (Fe, among others). $(RE)-(TM)_2-O_4$S include $ErFe_2O_4$, $LuFe_2O_4$ and $YFe_2O_4$.

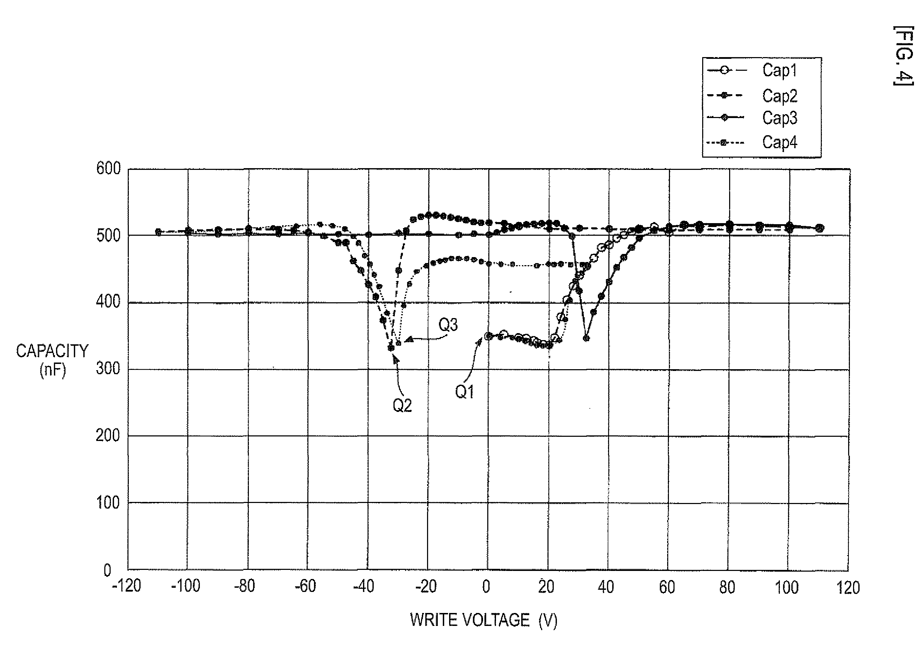

Next, Fig. 4 shows how the capacitance varied with the write voltage V further applied to the variable-capacitance element 100 shown in Fig. 1. A capacitance Cap1 in Fig. 4 is a measurement value similar to that shown in Fig. 2 and shows how the capacitance of the variable-capacitance element 100 varied with the write voltage V increasing from 0 V to 110 V.

A capacitance Cap2 in Fig. 4 shows how the capacitance of the variable-capacitance element 100 varied with the write voltage V decreasing from 110 V to -110 V.

A capacitance Cap3 in Fig. 4 shows how the capacitance of the variable-capacitance element 100 varied with the write voltage V increasing from -110 V to 110 V again.

A capacitance Cap4 in Fig. 4 shows how the capacitance of the variable-capacitance element 100 varied with the write voltage V increasing to approximately 40 V and then decreasing to -110 V, in which the variable-capacitance element 100 was heated to a temperature equal to or higher than the Curie temperature before the start of the measurement.

All of the capacitances Cap1, Cap2, Cap3 and Cap4 described above were measured after applying the write voltage V and then setting the voltage to 0 V once.

As seen from the capacitance Cap2 shown in Fig. 4, in the process of decreasing the write voltage V from 110 V to 0 V, the capacitance Cap2 was approximately constant. When the write voltage V was decreased from 0 V, the capacitance Cap2 started to increase mildly. Then, at a write voltage V of -20 V, the capacitance Cap2 started to decrease. The write voltage V causing the capacitance Cap2 to decrease is referred to as a depolarizing voltage. When the write voltage V is the depolarizing voltage, the polarizability in the ferroelectric material layer 103 decreases, causing the capacitance of the variable-capacitance element 100 to decrease. Then, while the write voltage V is the depolarizing voltage, applying a smaller write voltage V than a previously applied write voltage V enables the rewriting for decreasing the capacitance Cap2.

In this example embodiment, as shown in Fig. 4, the capacitance Cap2 was at its minimum at a write voltage V of -32.5V, and then, further decreasing the write voltage V caused the capacitance Cap2 to start to increase again. After applying the write voltage V at which the capacitance Cap2 started to increase again, applying a smaller write voltage V than a previously applied write voltage V enables the rewriting for increasing the capacitance Cap2. Then, after the write voltage V reached -60 V, the capacitance Cap2 was approximately constant. This variation in the capacitance Cap2 corresponds to the curve b of the hysteresis curve shown in Fig. 3. The write voltage V of -32.5 V at which the capacitance Cap2 was at its minimum corresponds to the negative coercive electric field Ec of the hysteresis curve in Fig. 3. At the coercive electric field Ec, the sum of electric dipole moments is at its minimum and the capacitance Cap2 is at its minimum. Also, the write voltage V of -60 V corresponds to the negative saturation electric field Ep of the variable-capacitance element 100. Then, when a write voltage V corresponding to the saturation electric field Ep is applied, the sum of electric dipole moments in the ferroelectric material layer 103 of the variable-capacitance element 100 is at its maximum, and the capacitance Cap2 is at its maximum.

Next, as seen from the capacitance Cap3 shown in Fig. 3, when increasing the write voltage V from -110 V, the capacitance Cap3 was approximately constant until 0 V, then started to increase mildly, and then started to decrease at 20 V. This means that, at 20 V, the write voltage V turned to the depolarizing voltage and the capacitance Cap3 started to decrease. While the write voltage V is the depolarizing voltage, applying a larger write voltage V than a previously applied write voltage V enables the writing for decreasing the capacitance Cap3. The capacitance Cap3 was at its minimum at a write voltage V of approximately 32.5 V. Then, increasing the write voltage V caused the capacitance Cap3 to start to increase again. After applying the write voltage V at which the capacitance Cap3 started to increase again, applying a larger write voltage V than a previously applied write voltage V enables the writing for increasing the capacitance Cap3. Then, after the write voltage V reached 60 V, the capacitance Cap3 was approximately constant. This variation in the capacitance Cap3 corresponds to the curve c of the hysteresis curve shown in Fig. 3. The write voltage V of 32.5 V at which the capacitance Cap3 of the variable-capacitance element 100 was at its minimum corresponds to the positive coercive electric field Ec of the hysteresis curve in Fig. 3.

In this way, the capacitance of the variable-capacitance element 100 including the ferroelectric material layer 103 shown in Fig. 1 varies as shown by the capacitances Cap1 to Cap3 in Fig. 4, due to the polarization P caused by the electric field E generated between the electrodes 101 and 102.

Further, as seen from the capacitance Cap1 to Cap3, according to the method for adjusting a variable-capacitance element of this example embodiment, applying an appropriate write voltage V can increase or decrease the capacitance.

Furthermore, the gradient of the capacitance Cap1 that was increased by applying a write voltage V after polarizing so as to minimize the sum of electric dipole moments in the ferroelectric material layer 103 by heating the variable-capacitance element 100 to a temperature equal to or higher than the Curie temperature to minimize the capacitance is larger than the gradient of the capacitance Cap3 that was increased by applying a write voltage V to polarize so as to minimize the sum of electric dipole moments in the ferroelectric material layer 103 to minimize the capacitance and further applying a write voltage V. Thus, according to the method for adjusting a variable-capacitance element of this example embodiment, initially polarizing the variable-capacitance element by heating to minimize the capacitance and then writing a capacitance provides a gentle gradient of variation in the capacitance with the write voltage V. This allows the capacitance to be more finely adjusted.

Also, as seen from the capacitance Cap4 in Fig. 4, in the case of increasing the write voltage V to only 40 V and then decreasing the write voltage V, the minimum of the capacitance Cap4 is larger than the minimum of the capacitance Cap2. The capacitance Cap4 is an example of not increasing the write voltage V to the saturation electric field Ep of the variable-capacitance element 100, while the capacitance Cap2 is an example of increasing the write voltage V to the saturation electric field Ec. In the comparison of the minimums of the capacitance Cap2 and the capacitance Cap4, the minimum of the capacitance Cap2, shown by "Q2", as a result of increasing the write voltage V to the saturation electric field Ep and then decreasing the write voltage V is smaller than the minimum of the capacitance Cap4, shown by "Q3", as a result of not increasing the write voltage V to the saturation electric field Ep.

The start point of the measurement of the capacitances Cap1 and Cap4, that is, the capacitance shown by "Q1" when the write voltage V is 0 V is a capacitance when the variable-capacitance element 100 was polarized by heating to a temperature equal to or higher than the Curie temperature. In the comparison of the capacitance shown by "Q1" and the capacitance shown by "Q2" minimized by polarizing the variable-capacitance element 100 by applying the write voltage V, the capacitance shown by "Q2" minimized by applying the write voltage V is smaller. Thus, according to the method for adjusting a variable-capacitance element of this example embodiment, minimizing the sum of electric dipole moments by polarizing the variable-capacitance element by applying the write voltage V can decrease the capacitance more effectively than minimizing the sum of electric dipole moments by polarizing the variable-capacitance element by heating to a temperature equal to or higher than the Curie temperature.

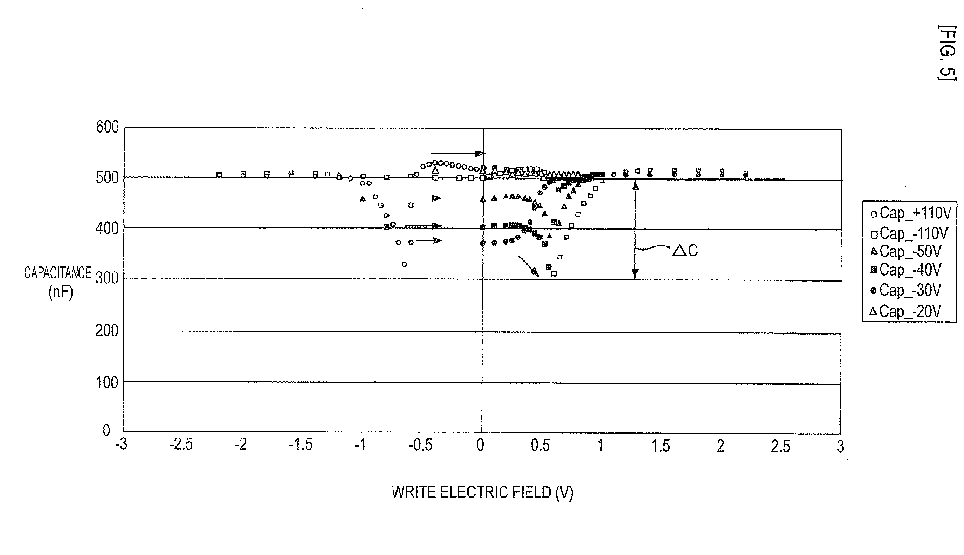

Fig. 5 shows a result of measurement of the capacitance. This measurement was performed by, first, polarizing the variable-capacitance element 100 so as to set the sum of electric dipole moments to zero by heating the variable-capacitance element 100 to a temperature equal to or higher than the Curie temperature, then, initially applying a write voltage V of +110 V, -110 V, -50 V, -40 V, -30 V or -20 V, and then, decreasing or increasing the write voltage V from each initially applied voltage and measuring the capacitance. In Fig. 5, the horizontal axis indicates the write electric field, and the vertical axis indicates the capacitance.

The capacitance Cap+110 V in Fig. 5 is a capacitance of the variable-capacitance element 100 when a write voltage V of 110 V was initially applied and then the write voltage V was decreased.

The capacitance Cap-110 V in Fig. 5 is a capacitance of the variable-capacitance element 100 when a write voltage V of -110 V was initially applied and then the write voltage V was increased.

The capacitance Cap-50 V in Fig. 5 is a capacitance of the variable-capacitance element 100 when a write voltage V of -50 V was initially applied and then the write voltage V was increased.

The capacitance Cap-40 V in Fig. 5 is a capacitance of the variable-capacitance element 100 when a write voltage V of -40 V was initially applied and then the write voltage V was increased.

The capacitance Cap-30 V in Fig. 5 is a capacitance of the variable-capacitance element 100 when a write voltage V of -30 V was initially applied and then the write voltage V was increased.

The capacitance Cap-20 V in Fig. 5 is a capacitance of the variable-capacitance element 100 when a write voltage V of -20 V was initially applied and then the write voltage V was increased.

As seen from Fig. 5, the amount of change $\Delta C$ from the minimum to the maximum of the capacitance in the case of initially applying a write voltage V of -110 V is larger than that in the case of initially applying any write voltage V the absolute value of which is less than 110 V.

This means that the capacitance in the case of initially causing the capacitance to be saturated by applying the saturation electric field Ep to the variable-capacitance element 100 and then applying the write voltage V can be smaller when the write voltage V is the depolarizing voltage, than the capacitance in the case of applying the write voltage V without initially causing the capacitance to be saturated. Thus, initially causing the capacitance to be saturated allows the capacitance to be adjusted within a greater range of the amount of change $\Delta C$.

As described above, according to the method for adjusting a variable-capacitance element in accordance with this example embodiment, applying a desired write voltage to a variable-capacitance element having a ferroelectric material layer can increase or decrease the capacitance of the variable-capacitance element.

With the variable-capacitance element initially heated to a temperature equal to or higher than the Curie temperature so as to minimize the sum of electric dipole moments, when applying the write voltage to increase the capacitance, the gradient of variation in the capacitance with the write voltage can be larger. This allows the capacitance to be more finely adjusted in applying the write voltage to the variable-capacitance element to write the desired capacitance.

Also, initially applying a saturation electric field Ep so as to maximize the sum of electric dipole moments allows the minimum of the capacitance to be smaller when applying the write voltage to decrease the capacitance. This allows the amount of change $\Delta C$ from the minimum to the maximum of the capacitance to be larger, enlarging the adjustable range of the capacitance of the variable-capacitance element.

In the variable-capacitance element having the ferroelectric material layer, the capacitance written by applying the write voltage is largely concerned with the polarized state of the ferroelectric material layer. However, only measuring the capacitance is not enough to determine the polarized state. In other words, as seen from the variation of the capacitances Cap1 to Cap3 shown in Fig. 4, the variation in the capacitance of the variable-capacitance element 100 having the ferroelectric material layer 103 depends on which state of the curves a, b and c in the hysteresis curve shown in Fig. 3 the variable-capacitance element 100 is in. This means that, even when the same write voltage V is applied, the capacitance to be written may be different due to the difference of the polarized state.

So, for the variable-capacitance element having the ferroelectric material layer, initializing the polarized state so as to maximize or minimize the sum of electric dipole moments enables the recognition of how the written capacitance varies with the write voltage V.

The write voltage for writing a desired capacitance depends on the relationship between temperature, time and voltage. For example, generally, at a high temperature (close to the Curie temperature), the desired capacitance can be written with a relatively low voltage and short writing time. By the way, this variable-capacitance element the capacitance of which is writable needs to be used under a control voltage that does not cause the capacitance to be varied. Under the condition of applying the write voltage V at the same temperature with the same applying time, when the control voltage has the same polarity as the write voltage, an applicable control voltage is less than the write voltage, and more preferably, is equal to or less than [write voltage] - [margin voltage]. When the control voltage has the opposite polarity to that of the write voltage, the applicable control voltage is equal to or less than the depolarizing voltage. Under the condition of applying the write voltage V at a different temperature, when the control voltage has the same polarity as the write voltage, the applicable control voltage is less than a coercive voltage at that temperature. When the control voltage has the opposite polarity to that of the write voltage, the applicable control voltage is less than a depolarizing voltage at that temperature. With such a control voltage, writing does not occur.

In order to prevent unwanted writing due to noise, the temperature when the capacitance is written to the variable-capacitance element is desirably set to a high temperature based on the applicable temperature range for the variable-capacitance element. Further, considering that a high voltage such as AC signal or electrostatic noise is applied for a very short length of time (e.g., in the order of milliseconds), the write voltage is desirably applied to the variable-capacitance element for a certain length of time (e.g., one second or more). This can prevent the capacitance from being rewritten by such an unwanted write voltage other than the write voltage to be applied to the variable-capacitance element.

[Variable-capacitance element in accordance with a first embodiment]

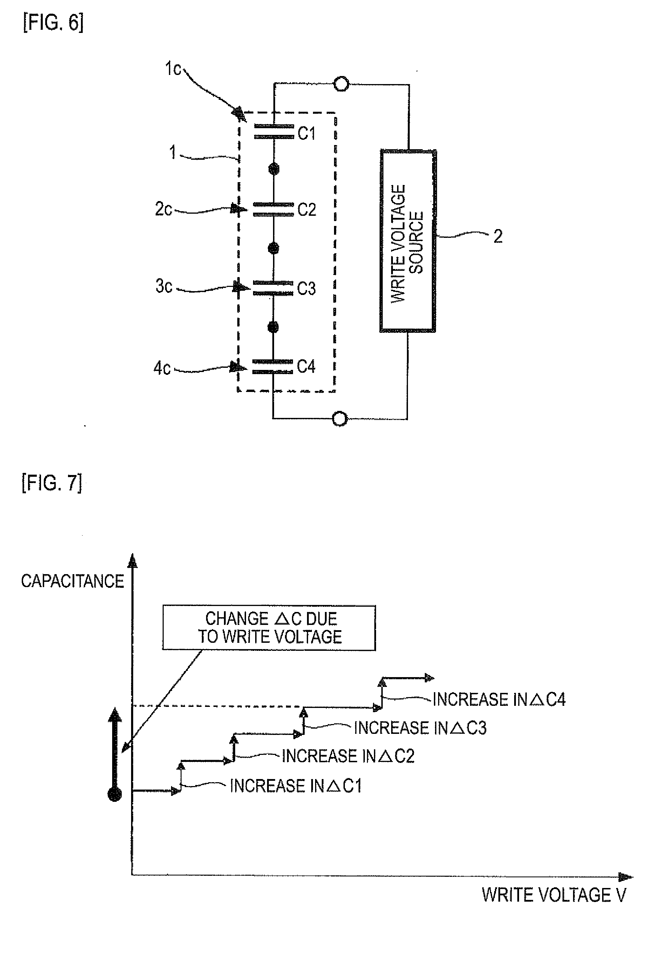

Next, a variable-capacitance element in accordance with a first embodiment of the invention is described with reference to Figs. 6 to 13.

The variable-capacitance element in this example embodiment is configured by connecting variable-capacitance elements 100 in Fig. 1 in series. In this example embodiment described below, for descriptive purposes, the variable-capacitance element 100 shown in Fig. 1 is referred to as a unit variable-capacitance element, and a plurality of unit variable-capacitance elements connected in series is referred to as a variable-capacitance element.

Fig. 6 shows a circuit in which a variable-capacitance element 1 is connected with a write voltage source 2, the variable-capacitance element 1 being configured by connecting rewritable unit variable-capacitance elements 1c to 4c in series, each having the property as shown in Figs. 2 to 5. The variable-capacitance element 1 in this example embodiment consists of the unit variable-capacitance elements 1c to 4c connected in series. Each of the unit variable-capacitance elements 1c to 4c includes a pair of electrodes with a ferroelectric material layer in between. The four unit variable-capacitance elements 1c to 4c have the same interelectrode distance d and have different capacitances $C_1$, $C_2$, $C_3$ and $C_4$, respectively, in unpolarized state. The magnitude relation between these capacitances is $C_1 < C_2 < C_3 < C_4$.

The write voltage V and the electric field E have the relation of $Ed = V$. So, with the same interelectrode distance d, the electric field E proportional to the write voltage V is generated in each of the unit variable-capacitance elements 1c to 4c. With the unit variable-capacitance elements 1c to 4c connected in series, the write voltage V is divided according to the capacitances $C_1$, $C_2$, $C_3$ and $C_4$. For example, a write voltage V1 applied to the unit variable-capacitance element 1c can be expressed as:

[Eq. 1]

$$V1 = V \times \frac{(1/C1)}{(1/C1) + (1/C2) + (1/C3) + (1/C4)}$$

So, in the circuit having the above-described configuration, with the write voltage V applied to the variable-capacitance element 1, the largest write voltage V1 is applied to the unit variable-capacitance element 1c having the smallest capacitance. Similarly, write voltages V2, V3 and V4 are applied to the unit variable-capacitance elements 2c, 3c and 4c, respectively. Since the unit variable-capacitance elements 1c to 4c have the same interelectrode distance d, electric fields E1 to E4 proportional to the write voltages V1 to V4 are generated in the unit variable-capacitance elements 1c to 4c, respectively. Therefore, the largest electric field E1 is generated in the unit variable-capacitance element 1c. Accordingly, when gradually increasing the write voltage V applied to the variable-capacitance element 1 shown in Fig. 6, polarization inversion starts to occur first in the unit variable-capacitance element 1c in which the largest electric field E1 is generated, and its capacitance starts to increase. Then, the capacitances of the unit variable-capacitance elements 2c to 4c start to increase in the order of smallest to largest capacitance.

Fig. 7 schematically shows how the capacitance of the variable-capacitance element 1 including the four unit variable-capacitance elements 1c to 4c connected in series of this example embodiment varies with the write voltage V applied to the variable-capacitance element 1. In Fig. 7, for clarification purposes, the respective capacitances C1 to C4 of the unit variable-capacitance elements 1c to 4c are shown such that they change instantaneously in a staircase pattern at certain voltage values. However, since the capacitances of the unit variable-capacitance elements 1c to 4c used in this example embodiment increase linearly with the applied write voltage V, the capacitance of the variable-capacitance element 1 actually varies mildly with the applied write voltage V.

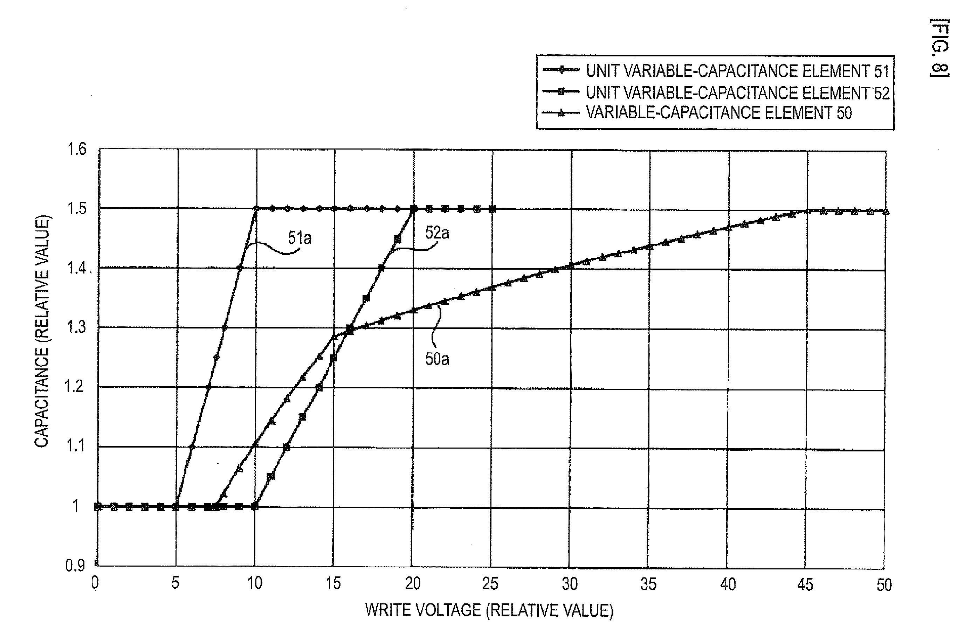

As an example, Fig. 8 shows how the capacitance of a variable-capacitance element 50 including two unit variable-capacitance elements connected in series varies with the write voltage, indicated by a line 50a, and how the capacitance of one unit variable-capacitance element 51 varies with the write voltage, indicated by a line 51a. Also, in Fig. 8, a line 52a indicates how the capacitance of one unit variable-capacitance element 52 having twice the interelectrode distance of the unit variable-capacitance element 51 varies with the write voltage.

First, consider how the capacitances of the unit variable-capacitance element 51 and the unit variable-capacitance element 52 vary. As seen, the capacitance of the unit variable-capacitance element 52 having twice the interelectrode distance starts to vary at twice the value of the write voltage at which the capacitance of the unit variable-capacitance element 51 starts to vary. Thus, as seem from the relation of Ed = V (E: electric field, d: interelectrode distance, V: write voltage), the longer the interelectrode distance d is, the larger the write voltage V that is needed for causing the capacitance to vary is.

Next, consider how the capacitance of the variable-capacitance element 50 including two unit variable-capacitance elements connected in series varies, indicated by the line 50a in Fig. 8. The capacitance ratio of the two unit variable-capacitance elements of the variable-capacitance element 50 is assumed to be 1:2. As seen, the capacitance of a variable-capacitance element including two unit variable-capacitance elements having different capacitances connected in series, such as the variable-capacitance element 50, can have a milder gradient of variation in the capacitance with the write voltage V than one unit variable-capacitance element, such as the unit variable-capacitance element 51 or 52.

Further, as seen from Figs. 7 and 8, the gradient can be still milder by increasing the number of unit variable-capacitance elements connected in series. Thus, configuring a variable-capacitance element by connecting unit variable-capacitance elements having different capacitances in unpolarized state in series can provide a smaller gradient of variation in the capacitance with the write voltage V. This can provide a variable-capacitance element the capacitance of which is finely adjustable.

Further, in the variable-capacitance element including unit variable-capacitance elements connected in series as described above, the unit variable-capacitance elements having different capacitances and the same interelectrode distance, the capacitances vary with the applied write voltage in the order from the unit variable-capacitance element having the smallest capacitance to that having the largest capacitance.

Also, in the variable-capacitance element including unit variable-capacitance elements connected in series as described above, each of the unit variable-capacitance elements has the property (as shown in Figs. 2 to 5) of the variable-capacitance element shown in Fig. 1. Thus, the capacitance of the variable-capacitance element varied by applying the write voltage is maintained even after setting the applied write voltage to 0 V.

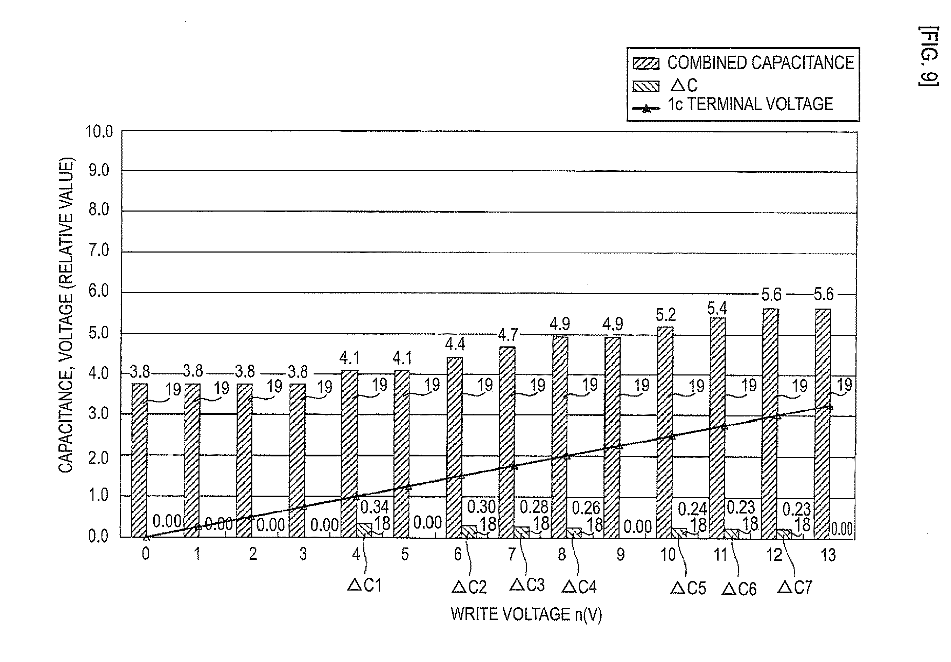

Fig. 9 shows the change ΔC in the capacitance of a variable-capacitance element versus the write voltage V, the variable-capacitance element including seven unit variable-capacitance elements 1c to 7c connected in series having capacitances C1 to C7 in unpolarized state expressed by relative values 15, 20, 25, 30, 35, 40 and 45, respectively. Fig. 9 also shows a relative value of the voltage between the terminals of the unit variable-capacitance element 1c. In this example, each of the unit variable-capacitance elements 1c to 7c has the same interelectrode distance d. Also, the unit variable-capacitance elements 1c to 7c have capacitances written and varied by the write voltage V1 to V7, respectively.

In Fig. 9, the write voltage V indicated by the horizontal axis is normalized by the write voltage V1, of the unit variable-capacitance element 1c and shows a write voltage nV that is n-times the write voltage V1 of the unit variable-capacitance element 1c. A measurement value indicated by a bar graph 19 is a combined capacitance measured when the write voltage V is nV. A measurement value indicated by a bar graph 18 is an increase ΔC in the combined capacitance when the write voltage V is changed from (n - 1)V to nV. The first increase in the combined capacitance is an increase ΔC1 in the capacitance C1 of the unit variable-capacitance element 1c. Then, the entire combined capacitance increases in the order of increases ΔC2 to ΔC7 in the capacitances C2 to C7 of the unit variable-capacitance elements 2c to 7c, respectively.

As seen from Fig. 9, the writing of the capacitance of the variable-capacitance element including the unit variable-capacitance elements 1c to 7c connected in series is started by applying a write voltage V that is approximately four times the write voltage v1 of the unit variable-capacitance element 1c. Then, the writing to all of the seven unit variable-capacitance elements 1c to 7c is completed by applying a write voltage V that is twelve times the write voltage V1. This means that all of the unit variable-capacitance elements 1c to 7c are polarized at this point. Then, the voltage applied to the terminals of the unit variable-capacitance element 1c when the writing to all of the unit variable-capacitance elements 1c to 7c is completed is approximately 3.3 times the write voltage V1 of the unit variable-capacitance element 1c. This means that, in the variable-capacitance element including the unit variable-capacitance elements 1c to 7c connected in series, the number of unit variable-capacitance elements connected in series can be increased unless the voltage applied to the terminals of the unit variable-capacitance element 1c having the smallest capacitance C1 exceeds the withstand voltage.

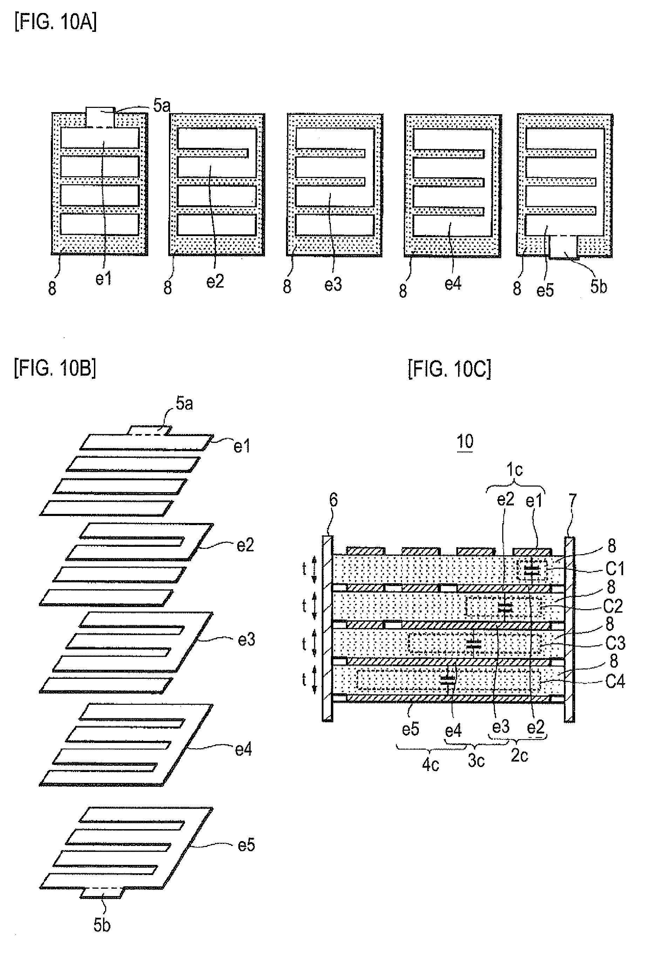

Fig. 10 shows a specific configuration of a variable-capacitance element including unit variable-capacitance elements connected in series. In the example shown in Fig. 10, the variable-capacitance element is configured by connecting four unit variable-capacitance elements in series.

First, Fig. 10A shows in-plane electrodes included in the variable-capacitance element including unit variable-capacitance elements connected in series. Five in-plane electrodes e1 to e5 are used to form the four unit variable-capacitance elements. Each of the in-plane electrodes e1 to e5 is formed by patterning a desired shape on a ferroelectric material layer 8, for example. In the example shown in Fig. 10A, each of the in-plane electrodes e1 to e5 is formed by patterning four strip-shaped equivalent unit electrodes on the ferroelectric material layer 8. Then, the relation of connection between the four unit electrodes is varied to form each of the in-plane electrodes e1 to e5. Specifically, in the in-plane electrode e1, the four unit electrodes are not connected to each other; in the in-plane electrode e2, two of the four unit electrodes are connected to each other; in the in-plane electrode e3, three of the four unit electrodes are connected to each other; and in the in-plane electrodes e4 and e5, all of the four unit electrodes are connected to each other. The electrode areas of the in-plane electrodes e1 to e5 are equivalently varied. Also, in the example shown in Fig. 10A, a first external electrode 5a integrated with the in-plane electrode e1 and a second external electrode 5b integrated with the in-plane electrode e5 are provided.

These in-plane electrodes e1 to e5 are stacked as shown in Fig. 10B to form a variable-capacitance element 10 shown in Fig. 10C. Fig. 10C shows a schematic sectional configuration of the variable-capacitance element 10 configured in this example. In the variable-capacitance element 10 shown in Fig. 10C, the in-plane electrodes e1 to e5 are stacked in the order of e5, e4, e3, e2, e1 from the bottom with the same interelectrode distance t maintained by the ferroelectric material layers 8 disposed between the in-plane electrodes. As a result of stacking the in-plane electrodes as above, the in-plane electrodes e1 and e2 form a unit variable-capacitance element 1c; the in-plane electrodes e2 and e3 form a unit variable-capacitance element 2c; the in-plane electrodes e3 and e4 form a unit variable-capacitance element 3c; and the in-plane electrodes e4 and e5 form a unit variable-capacitance element 4c.

The first external electrode 5a is provided on the in-plane electrode e1 stacked at the top. The second external electrode 5b is provided on the in-plane electrode e5 stacked at the bottom. Then, the first external electrode 5a is connected to an external terminal 7, and the second external electrode 5b is connected to an external terminal 6, thereby configuring the variable-capacitance element 10 including the unit variable-capacitance elements 1c to 4c connected in series. In this example, the write voltage is applied between the external terminals 6 and 7.

In each of the in-plane electrodes e1 to e5 of the variable-capacitance element 10 shown in Fig. 10C, signal is not input to an unconnected unit electrode, so a portion sandwiched between unconnected unit electrodes does not function as an effective capacitance. In other words, only connected unit electrodes of the in-plane electrodes e1 to e5 contribute to the effective capacitance. Accordingly, in the variable-capacitance element 10 stacked as shown in Fig. 10C, the unit variable-capacitance element 1c formed of the in-plane electrodes e1 and e2 provides a capacitance C1 corresponding to one pair of unit electrodes; the unit variable-capacitance element 2c formed of the in-plane electrodes e2 and e3 provides a capacitance C2 corresponding to two pairs of unit electrodes; the unit variable-capacitance element 3c formed of the in-plane electrodes e3 and e4 provides a capacitance C3 corresponding to three pairs of unit electrodes; and the unit variable-capacitance element 4c formed of the in-plane electrodes e4 and e5 provides a capacitance C4 corresponding to four pairs of unit electrodes. Then, the capacitances C1 to C4 are equivalently connected in series.

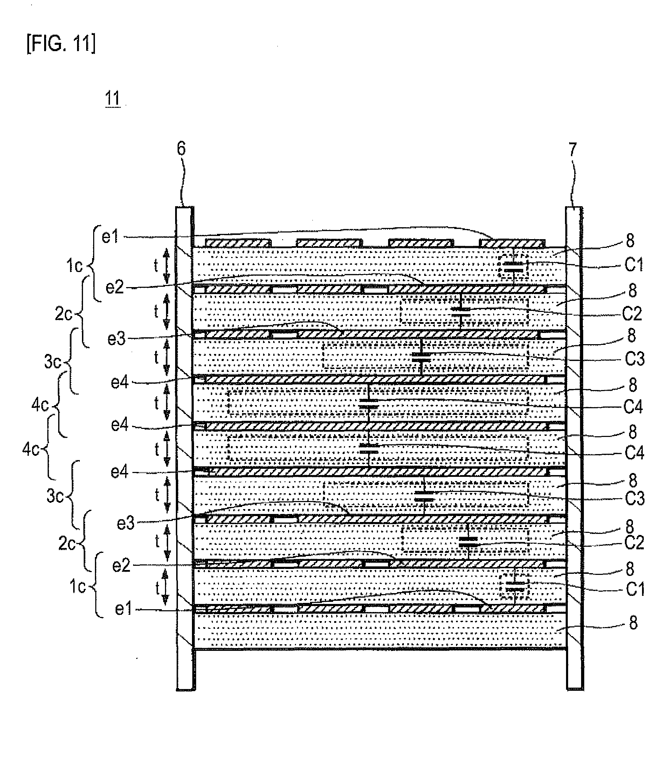

Using the in-plane electrodes e1 to e4 shown in Fig. 10A, a variable-capacitance element having a larger total capacitance can be configured. As shown in Fig. 11, this is achieved by stacking two stacked object each including the in-plane electrodes e1 to e4 symmetrically to each other with another in-plane electrode e4 in between. A portion in Fig. 11 that is described with reference to Fig. 10 is denoted by the same numeral, and will not be repeatedly described.

A variable-capacitance element 11 shown in Fig. 11 includes two groups of stacked in-plane electrodes e1 to e4, the stacking orders being opposite to each other, with the in-plane electrode e5 disposed between the two groups.

Also in the variable-capacitance element 11 shown in Fig. 11, a first external electrode 5a is formed on the in-plane electrode e1 stacked at the top, and a second external electrode 5b is formed on the in-plane electrode e1 stacked at the bottom. Then, the first external electrode 5a is connected to an external terminal 7, and the second external electrode 5b is connected to an external terminal 6, thereby configuring the variable-capacitance element 11 including the unit variable-capacitance elements 1c to 4c equivalently connected in series.

In the variable-capacitance element 11 shown in Fig. 11, the unit variable-capacitance elements are connected in series in the order of 1c, 2c, 3c, 4c, 4c, 3c, 2c, 1c from the top.

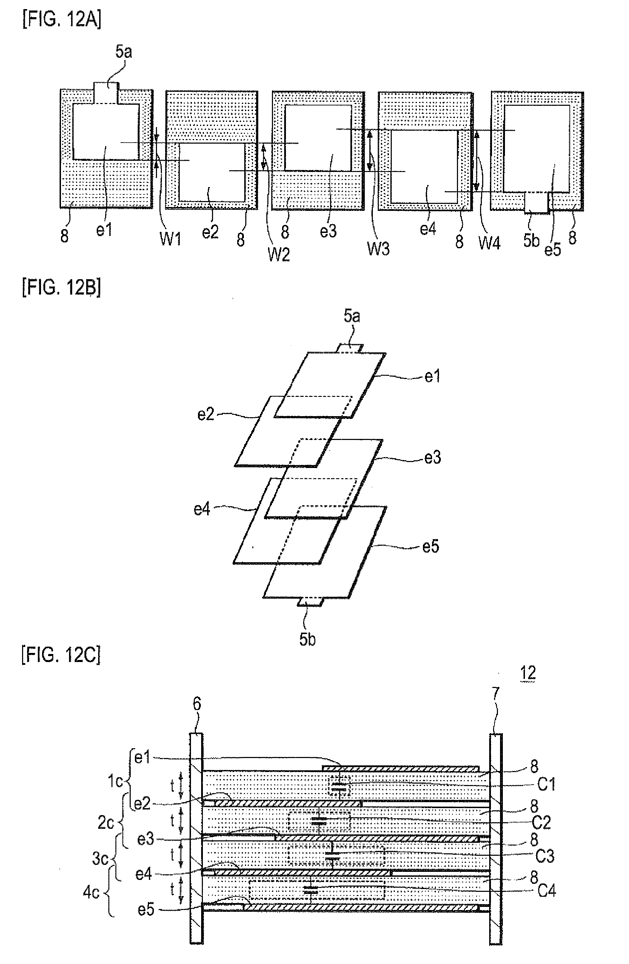

Next, Fig. 12 shows another example of specific configuration of the variable-capacitance element including unit variable-capacitance elements connected in series.

First, Fig. 12A shows in-plane electrodes e1 to e5 included in the variable-capacitance element. In this example, the in-plane electrodes e1 to e4 are patterned on ferroelectric material layers 8 such that their electrode areas are different from each other. Also in the example shown in Fig. 12A, a first external electrode 5a is formed on the edge of the in-plane electrode e1, and a second external electrode 5b is formed on the edge of the in-plane electrode e5.

For example, the in-plane electrodes e1 to e5 are formed such that the electrode area gradually increases from e1 to e5 so that, when the in-plane electrodes e1 to e5 are stacked as shown in Fig. 12B, the overlapping area of the in-plane electrodes e1 and e2 is W1; the overlapping area of the in-plane electrodes e2 and e3 is W2; the overlapping area of the in-plane electrodes e3 and e4 is W3; and the overlapping area of the in-plane electrodes e4 and e5 is W4.

Fig. 12C shows a schematic sectional configuration of the variable-capacitance element 12 formed in this example. In the variable-capacitance element 12, the in-plane electrodes e1 to e5 having different areas are stacked in the order of e5, e4, e3, e2, e1 from the bottom with the same interelectrode distance t maintained by ferroelectric material layers 8 having the same thickness disposed between the in-plane electrodes. As a result of stacking the in-plane electrodes as above, the in-plane electrodes e1 and e2 form a unit variable-capacitance element 1c; the in-plane electrodes e2 and e3 form a unit variable-capacitance element 2c; the in-plane electrodes e3 and e4 form a unit variable-capacitance element 3c; and the in-plane electrodes e4 and e5 form a unit variable-capacitance element 4c.

Then, the first external electrode 5a is connected to an external terminal 7, and the second external electrode 5b is connected to an external terminal 6, thereby configuring the variable-capacitance element 12 including the unit variable-capacitance elements 1c to 4c connected in series. In this example, the write voltage is applied between the external terminals 6 and 7.

In the example shown in Fig. 12, overlapping areas of the adjacent in-plane electrodes with the ferroelectric material layers 8 in between can be varied by stacking the in-plane electrodes e1 to e5 having different areas, According to this configuration, in the variable-capacitance element 12 shown in Fig. 12C, the unit variable-capacitance element 1c formed of the in-plane electrodes e1 and e2 provides a capacitance value C1 corresponding to the overlapping area W1; the unit variable-capacitance element 2c formed of the in-plane electrodes e2 and e3 provides a capacitance value C2 corresponding to the overlapping area W2; the unit variable-capacitance element 3c formed of the in-plane electrodes e3 and e4 provides a capacitance value C3 corresponding to the overlapping area W3; and the unit variable-capacitance element 4c formed of the in-plane electrodes e4 and e5 provides a capacitance value C4 corresponding to the overlapping area W4.

In the variable-capacitance element 12 shown in Fig. 12C, the interelectrode distance t between the in-plane electrodes is constant, and the electrode areas of the unit variable-capacitance elements 1c to 4c are different from each other. In this example, the relation between the capacitances of the unit variable-capacitance elements 1c to 4c is $C1 < C2 < C3 < C4$.

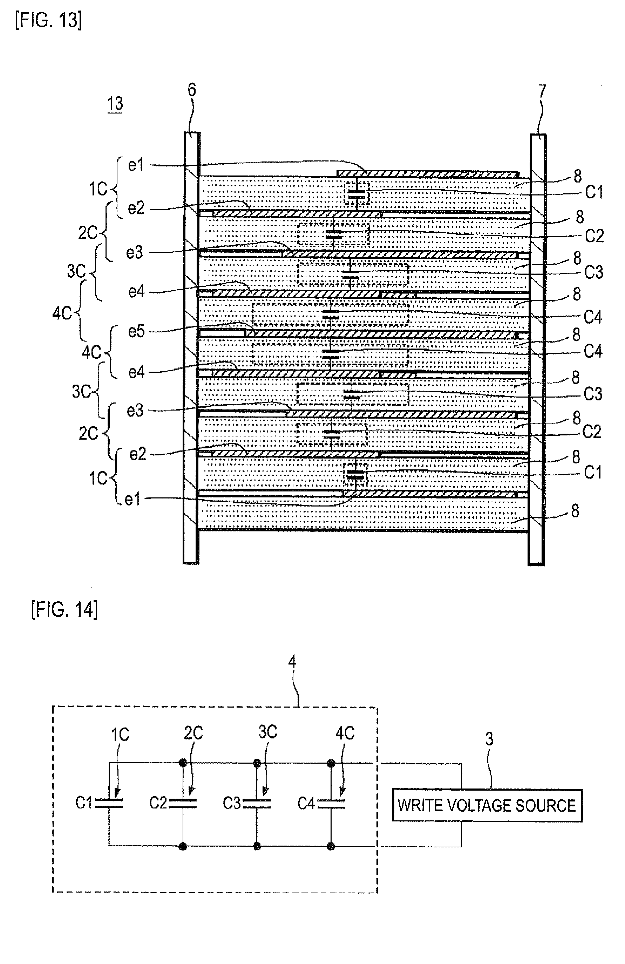

Also in the example shown in Fig. 12, in order to achieve a larger total capacitance, as shown in Fig. 13, two variable-capacitance elements each including one stacked object of the in-plane electrodes e1 to e4 can be stacked symmetrically to each other with another in-plane electrode e5 in between. Thus, the variable-capacitance element 13 in Fig. 13 includes two groups of stacked in-plane electrodes e1 to e4, the stacking orders being opposite to each other, with the in-plane electrode e5 disposed between the two groups. A portion in Fig. 13 that is described with reference to Fig. 12 is denoted by the same numeral, and will not be repeatedly described.

In the variable-capacitance element 13 shown in Fig. 13, a first external electrode 5a is formed on the in-plan electrode e1 stacked at the top, and a second external electrode 5b is formed on the in-plane electrode e1 stacked at the bottom. Then, the first external electrode 5a is connected to an external terminal 7, and the second external electrode is connected to an external terminal 6, thereby configuring the variable-capacitance element 13 including the unit variable-capacitance elements 1c, 2c, 3c, 4c, 4c, 3c, 2c and 1c equivalently connected in series.

In the variable-capacitance element 13 shown in Fig. 13, the capacitances of the unit variable-capacitance elements 1c, 2c, 3c, 4c, 4c, 3c, 2c and 1c are C1, C2, C3, C4, C4, C3, C2 and C1, respectively. Then, when a write voltage gradually increasing from 0 V is applied between the external terminals 6 and 7 of the variable-capacitance element 13, the unit variable-capacitance elements are sequentially polarized in the order from the unit variable-capacitance element 1c having the smallest capacitance, thereby gradually increasing the combined capacitance, as shown in Fig. 9. Also in this case, the capacitance is maintained after stopping applying the write voltage.

[Variable-capacitance element in accordance with a second embodiment]

Next, a variable-capacitance element in accordance with a second embodiment of the invention is described with reference to Figs. 14 to 17. The variable-capacitance element in this example embodiment includes variable-capacitance elements described with reference to Fig. 1 connected in parallel. In the example embodiment described below, for descriptive purposes, the variable-capacitance element described with reference to Fig. 1 is referred to as a unit variable-capacitance element, and a plurality of unit variable-capacitance elements connected in parallel is referred to as a variable-capacitance element.

Fig. 14 shows a circuit in which four writable unit variable-capacitance elements 1c to 4c are connected in parallel with a write voltage source 3. As shown in this example embodiment, in a variable-capacitance element 4 including the unit variable-capacitance elements 1c to 4c connected in parallel, the same write voltage V is applied to all of the unit variable-capacitance elements 1c to 4c. In order to gradually vary the capacitance of the variable-capacitance element 4 with the applied write voltage V, electric field E generated in each of the unit variable-capacitance elements 1c to 4c needs to be varied. In this example embodiment, in order to vary the generated electric field E with the same write voltage, the interelectrode distance d is varied for each of the unit variable-capacitance elements 1c to 4c according to the relation of Ed = V. Varying the interelectrode distance d causes the generated electric field E to vary for each of the unit variable-capacitance elements 1c to 2c when the same write voltage V is applied. Accordingly, the write voltage V at which the capacitance starts to vary can be varied among the unit variable-capacitance elements 1c to 4c. In this way, varying the write voltage V at which the capacitance starts to vary allows the capacitance of the variable-capacitance element 4 to gradually vary.

Also in this example, in order to equalize the capacitances in unpolarized state C1 to C4 of the unit variable-capacitance elements 1c to 4c with the interelectrode distance d varied, the electrode area of each of the unit variable-capacitance elements 1c to 4c can be varied.

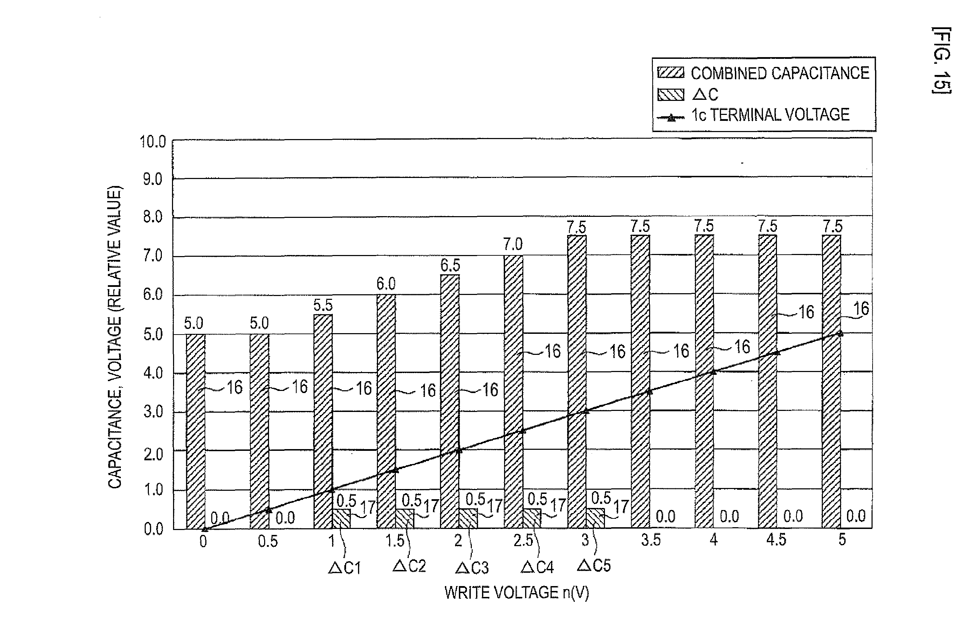

For a variable-capacitance element including five unit variable-capacitance elements 1c to 5c having the same capacitances in unpolarized state C1 to C4, respectively, connected in parallel, Fig. 15 shows the variation in the capacitance and the relative value of the voltage applied between the terminals of the unit variable-capacitance element 1c, versus the write voltage. The unit variable-capacitance elements 1c to 5c have the same capacitances C1 to C4 and have withstand voltages (relative value) of 1, 1.5, 2, 2.5 and 3, respectively. The write voltage indicated by the horizontal axis is normalized by the write voltage of the unit variable-capacitance element 1c and shows a write voltage n (V) that is n-times the write voltage of the unit variable-capacitance element 1c. A measurement value indicated by a bar graph 16 is a combined capacitance measured when the write voltage V is n (V). A measurement value indicated by a bar graph 17 is an increase $\Delta C$ in the combined capacitance when the write voltage V is changed from n - 1 (V) to n (V). The first increase $\Delta C$ in the combined capacitance is an increase $\Delta C1$ in the capacitance C of the unit variable-capacitance element 1c. Then, the entire combined capacitance increases in the order of increases $\Delta C2$, $\Delta C3$, $\Delta C4$, $\Delta C5$ as the write voltage increases.

As seen from Fig. 15, in the variable-capacitance element including the five unit variable-capacitance elements 1c to 5c, having the same capacitances, connected in parallel, writing to the unit variable-capacitance element 1c starts when a write voltage is applied to the unit variable-capacitance element 1c. Then, when twelve times the write voltage is applied, writing to all of the five elements is performed. This means that applying a write voltage that is twelve times the write voltage of the unit variable-capacitance element 1c polarizes the five unit variable-capacitance elements 1c to 5c. The write voltage applied between the terminals of each of the unit variable-capacitance elements 1c to 5c when writing to the unit variable-capacitance elements 1c to 5c is performed is approximately three times the write voltage of the unit variable-capacitance element 1c. Unless this voltage exceeds the withstand voltage, the number of unit variable-capacitance elements connected in parallel can be increased.

Also in the case of connecting the unit variable-capacitance elements 1c to 5c in parallel as seen in this example embodiment, with the unit variable-capacitance elements 1c to 5c having the same capacitances C, the capacitance of the variable-capacitance element can be incremented by a constant amount of change $\Delta C$ as the write voltage increases.

For the variable-capacitance element including the unit variable-capacitance elements 1c to 5c connected in parallel as seen in this example embodiment, the write voltage is determined only by the individual specifications of the unit variable-capacitance elements, and is not influenced by an interaction between the unit variable-capacitance elements. Accordingly, as a feature of this type of variable-capacitance element, it is easier to equalize the amount of capacitance change $\Delta C$ and reduce the maximum write voltage than the variable-capacitance element including unit variable-capacitance elements connected in series.

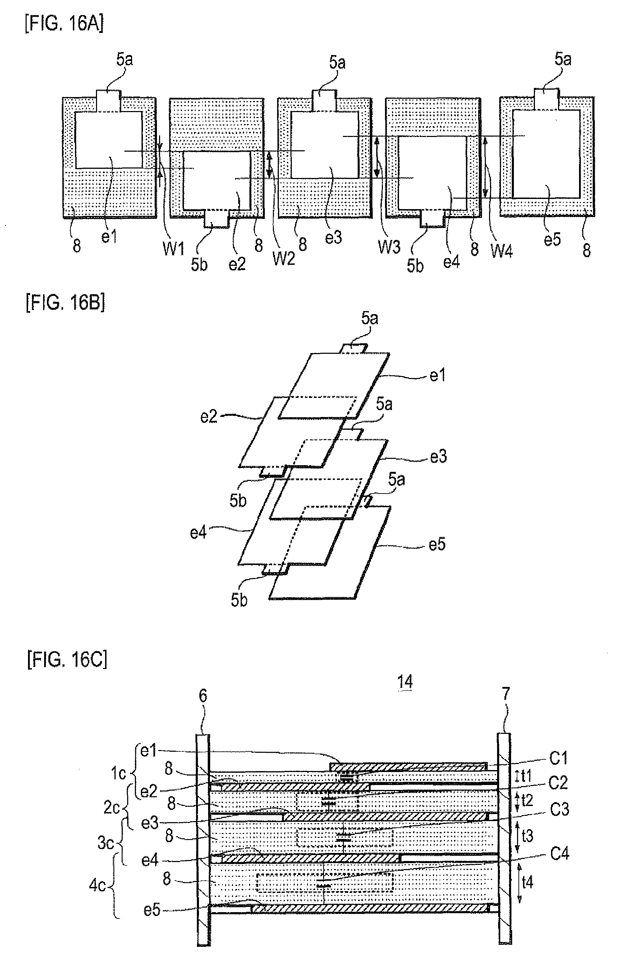

Fig. 16 shows a specific configuration of a variable-capacitance element including unit variable-capacitance elements connected in parallel.

Also in the variable-capacitance element including unit variable-capacitance elements connected in parallel, a plurality of in-plane electrodes having different areas can be used as the example shown in Fig. 12.

Fig. 16A shows in-plane electrodes e1 to e5 included in the variable-capacitance element. In this example, the in-plane electrodes e1 to e5 are patterned on ferroelectric material layers 8 such that their electrode areas are different from each other. Also in the example shown in Fig. 16, first external electrodes 5a are formed on the edges of the in-plane electrodes e1, e3 and e5, and second external electrodes 5b are formed on the edges of the in-plane electrodes e2 and e4. When the in-plane electrodes are stacked as shown in Fig. 16B, the first external electrodes 5a are formed on the in-plane electrodes stacked in odd-numbered positions from the bottom, and the second external electrodes 5b are formed on the in-plane electrodes stacked in even-numbered positions from the bottom.

For example, the in-plane electrodes e1 to e5 are formed such that the electrode area gradually increases from e1 to e5 so that, when the in-plane electrodes e1 to e5 are stacked as shown in Fig. 16B, the overlapping area of the in-plane electrodes e1 and e2 is W1; the overlapping area of the in-plane electrodes e2 and e3 is W2; the overlapping area of the in-plane electrodes e3 and e4 is W3; and the overlapping area of the in-plane electrodes e4 and e5 is W4. In this example, the relation between the overlapping areas of the adjacent in-plane electrodes is W1 < W2 < W3 < W4.

Fig. 16C shows a schematic sectional configuration of a variable-capacitance element 14 configured in this example. In the variable-capacitance element 14, the in-plane electrodes e1 to e5 having different areas are stacked in the order of e5, e4, e3, e2, e1 from the bottom, and four ferroelectric material layers 8 with thicknesses of t4, t3, t2, t1 in this order from the bottom are disposed between the adjacent in-plane electrodes, as shown in Fig. 16C, where t4 is the interelectrode distance of the in-plane electrodes e5 and e4, t3 is the interelectrode distance of the in-plane electrodes e4 and e3, t2 is the interelectrode distance of the in-plane electrodes e3 and e2, t1 is the interelectrode distance of the in-plane electrodes e2 and e1, and t1 < t2 < t3 < t4. As a result of stacking the in-plane electrodes as above, the in-plane electrodes e1 and e2 form a unit variable-capacitance element 1c; the in-plane electrodes e2 and e3 form a unit variable-capacitance element 2c; the in-plane electrodes e3 and e4 form a unit variable-capacitance element 3c; and the in-plane electrodes e4 and e5 form a unit variable-capacitance element 4c.

Then, the first external electrodes 5a formed on the in-plane electrodes e1 e3 and e5 are connected to an external terminal 7, and the second external electrodes 5b formed on the in-plane electrodes e2 and e4 are connected to an external terminal 6. In this way, the variable-capacitance element 14 including the unit variable-capacitance elements 1c to 4c connected in parallel is configured. In this example, the write voltage is applied between the external terminals 6 and 7.

In the example shown in Fig. 16, overlapping areas of the adjacent in-plane electrodes with the ferroelectric material layers 8 in between can be varied by stacking the in-plane electrodes e1 to e5 having different areas. According to this configuration, in the variable-capacitance element 14 shown in Fig. 16C, the unit variable-capacitance element 1c formed of the in-plane electrodes e1 and e2 provides a capacitance value C1 corresponding to the overlapping area W1; the unit variable-capacitance element 2c formed of the in-plane electrodes e2 and e3 provides a capacitance value C2 corresponding to the overlapping area W2; the unit variable-capacitance element 3c formed of the in-plane electrodes e3 and e4 provides a capacitance value C3 corresponding to the overlapping area W3; and the unit variable-capacitance element 4c formed of the in-plane electrodes e4 and e5 provides a capacitance value C4 corresponding to the overlapping area W4. In the variable-capacitance element including the unit variable-capacitance elements connected in parallel, in order to equalize the amount of capacitance change ($\Delta C$ shown in Fig. 15) of the unit variable-capacitance elements 1c to 4c, the capacitances C1 to C4 are preferably the same as each other. In this example, since the interelectrode distances t1 to t4 are different from each other, the capacitances C1 to C4 can be the same as each other by appropriately determining the overlapping areas W1 to W4.

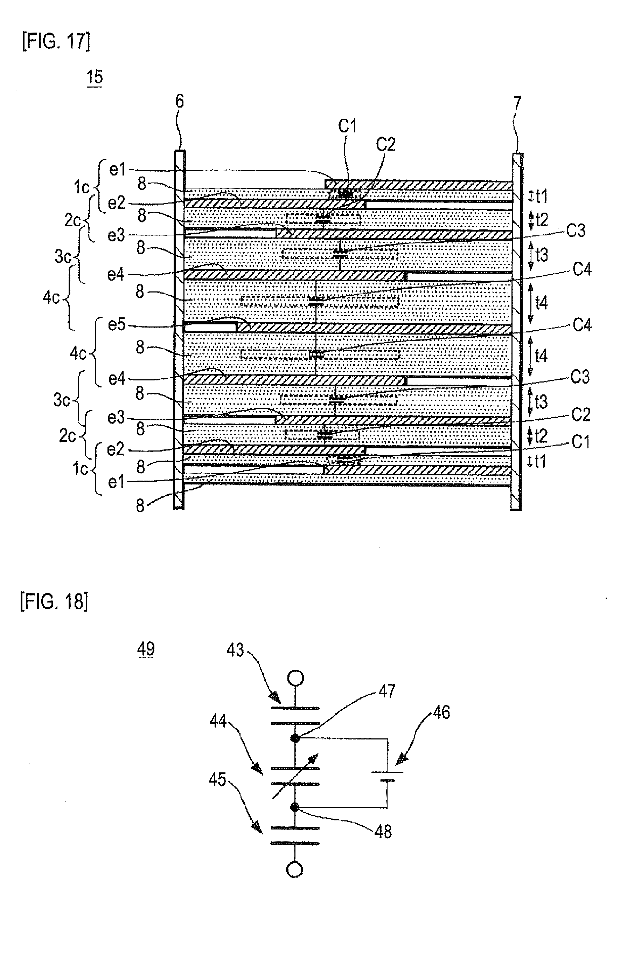

Also in this example, in order to achieve a larger total capacitance, as shown in Fig. 17, two variable-capacitance elements each including one stacked object of the in-plane electrodes e1 to e4 can be stacked symmetrically to each other with another in-plane electrode e5 in between to configure a variable-capacitance element 15. Thus, the variable-capacitance element 15 in Fig. 17 includes two groups of stacked in-plane electrodes e1 to e4, the stacking orders being opposite to each other, with the in-plane electrode e5 disposed between the two groups. A portion in Fig. 17 that is described with reference to Fig. 16 is denoted by the same numeral, and will not be repeatedly described.

Also in the variable-capacitance element 15 shown in Fig. 17, first external electrodes 5a connected to a external terminal 7 are formed on the in-plane electrodes e1, e3 and e5, and second external electrodes 5b connected to a external terminal 6 are formed on the in-plane electrodes e2 and e4. In this way, the variable-capacitance element 15 including the unit variable-capacitance elements 1c, 2c, 3c, 4c, 4c, 3c, 2c and 1c equivalently connected in parallel is configured.

In the variable-capacitance element 15 shown in Fig. 17, the capacitances of the unit variable-capacitance elements 1c, 2c, 3c, 4c, 4c, 3c, 2c and 1c are C1, C2, C3, C4, C4, C3, C2 and C1, respectively. Then, when an increasing write voltage is applied between the external terminals 6 and 7 of the variable-capacitance element 15, the unit variable-capacitance elements 1c to 4c are sequentially polarized and have their capacitances varied and maintained in the order from the unit variable-capacitance element 1c having the smallest interelectrode distance.

In the variable-capacitance element in accordance with the first and second embodiments of the invention as described above, each unit variable-capacitance element included in the variable-capacitance element has a characteristic shown in Figs. 2 to 5. Accordingly, the method for adjusting a variable-capacitance element in accordance with one embodiment of the invention described above can be applied to the first and second embodiments.

Then, the capacitance of the variable-capacitance element can be set to a desired capacitance by applying a write voltage to the variable-capacitance element as described in the first and second embodiments. Also, as described in the first and second embodiments, configuring the variable-capacitance element by connecting a plurality of unit variable-capacitance elements in series or parallel allows the gradient of capacitance change versus the increasing write voltage to be mild. Accordingly, the capacitance of the variable-capacitance element described in the first and second embodiments can be adjusted more precisely.

[Variable-capacitance device and electronic apparatus]

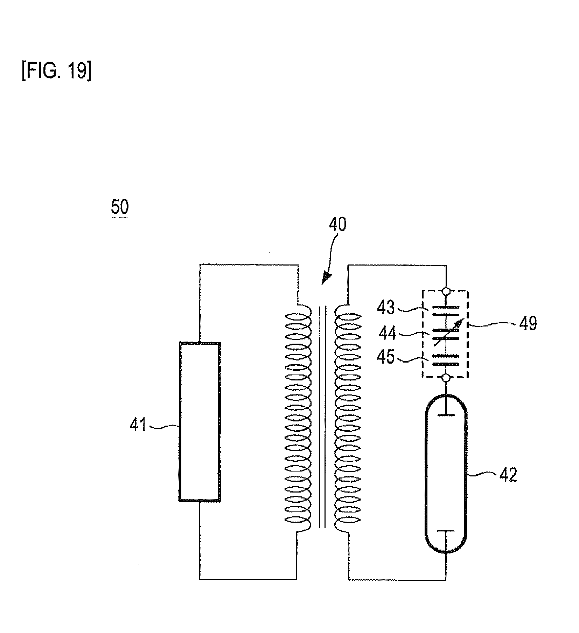

Next, a variable-capacitance device including the variable-capacitance element in accordance with the invention and an electronic apparatus including the variable-capacitance device are described. Fig. 18 shows a schematic configuration of the variable-capacitance device. As an example of the electronic apparatus, Fig. 19 shows an inverter circuit configuration for a cold cathode fluorescent lamp (CCFL) back light used for a liquid crystal television or the like.

A variable-capacitance device 49 shown in Fig. 18 includes: a variable-capacitance element 44 including a pair of electrodes formed with a ferroelectric material layer in between; capacitance elements 43 and 45 for eliminating dc voltage disposed on both sides of the variable-capacitance element 44 and connected to the variable-capacitance element 44 in series; and external input terminals 47 and 48 connected to the variable-capacitance element 44 for applying a write voltage V across the variable-capacitance element 44 from a dc voltage source 46. In this example, the variable-capacitance element 44 including a pair of electrodes formed with a ferroelectric material layer in between may be, for example, a variable-capacitance element as shown in Fig. 1 or a variable-capacitance element including a plurality of unit variable-capacitance elements connected in series or parallel as described above. For employing the variable-capacitance element including a plurality of unit variable-capacitance elements connected in series or parallel, the variable-capacitance element in accordance with the first and second embodiments described above.

The variable-capacitance device 49 includes the capacitance elements 43 and 45 for eliminating dc voltage disposed on both sides of the variable-capacitance element 44. Accordingly, with this variable-capacitance device 49 built into an electric circuit of the electronic apparatus, when an external dc voltage source is connected to the external input terminals 47 and 48 and a write voltage V is applied to the variable-capacitance element 44, the capacitance elements 43 and 45 for eliminating dc voltage can prevent the write voltage V from being applied to the circuit of the electronic apparatus.

The variable-capacitance device 49 configured as above is, for example, built into the inverter circuit for CCFL back light as shown in Fig. 19. The inverter circuit shown in Fig. 19 includes a CCFL 42, a step-up transformer 40 connected to the CCFL 42, and a drive circuit 41 for driving the step-up transformer 40. A ballast capacitor including the variable-capacitance device 49 is connected between the CCFL 42 and the step-up transformer 40.

Although only one CCFL 42 is shown in Fig. 19, two CCFLs 42 connected in parallel may also be used. For the CCFL 42, a high dc voltage boosted by the step-up transformer 40 is applied to the CCFL 42 through the variable-capacitance device 49 as ballast capacitor. The output of the step-up transformer 40 is normally 1500 V and 50 kHz or so. The current flowing in the CCFL 42 is 5 to 10 mA. The ballast capacitor including the variable-capacitance device 49 is used for separating two CCFLs 42 from each other in driving the CCFLs 42 in parallel, and may include a transformer in addition to the capacitors.

By the way, the purpose of using the ballast capacitor in the CCFL back light is to reduce the cost. However, one disadvantage is that the amount of current may vary between the CCFLs to cause unevenness of luminance due to variation in capacitance of the CCFLs or variation in stray capacitance between the CCFLs and the surrounding metal members.

In order to overcome this disadvantage, the variable-capacitance element 44 is adjusted for each variable-capacitance device 49 included in each ballast capacitor.

In order to adjust the capacitance of the variable-capacitance element 44 in the variable-capacitance device 49, a write voltage is applied between the external input terminals 47 and 48 connected to the variable-capacitance element 44 in the variable-capacitance device 49. Then, the capacitance of the variable-capacitance element 44 is adjusted by applying a desired write voltage. Since the write voltage is a dc voltage, applying a high dc voltage across the step-up transformer 40 as shown may cause excess current to flow through the transformer coil. However, in this example, the variable-capacitance device 49 includes the capacitance elements 43 and 45 for eliminating dc voltage disposed on both sides of the variable-capacitance element 44. Accordingly, when the write voltage is applied to the variable-capacitance device 49 to adjust the capacitance of the variable-capacitance element 44 in the variable-capacitance device 49, dc voltage is never applied to the step-up transformer 40 and the CCFL 42. This allows the capacitance to be adjusted by applying a voltage to the variable-capacitance device 49 when implemented. Then, in the CCFL back light including this variable-capacitance device 49, the variable-capacitance element 44 is adjusted so as to equalize the luminance of the CCFLs 42.

In this example, the CCFL back light is described as an example of the electronic apparatus including the variable-capacitance device shown in Fig. 18. However, the variable-capacitance device may also be built into other electronic apparatuses, such as a non-contact IC card. Thus, building the variable-capacitance device in accordance with the invention into an electronic apparatus allows a write voltage to be applied to the variable-capacitance element in the variable-capacitance device to achieve a desired capacitance without influencing other circuits in the electronic apparatus. Then, adjusting the variable-capacitance element in the variable-capacitance device so that the variable-capacitance element has a desired capacitance allows the shift in tuning frequency due to component-to-component variations to be corrected before shipping.

**Claims**

1. A variable-capacitance element, **characterized in that**:

   a plurality of unit variable-capacitance elements are connected in series or parallel, each of the unit variable-capacitance elements including a pair of electrodes formed with a ferroelectric material layer in between.

2. The variable-capacitance element according to claim 1, **characterized in that**:

   interelectrode distances of the unit variable-capacitance elements connected in parallel are different from each other.

3. The variable-capacitance element according to claim 2, **characterized in that**:

   the capacitances of the unit variable-capacitance elements connected in parallel are the same as each other when the sum of electric dipole moments of the ferroelectric material layer of each of the unit variable-capacitance elements is minimized.

4. The variable-capacitance element according to claim 1, **characterized in that**:

   the capacitances of the unit variable-capacitance elements connected in series are different from each other when the sum of electric dipole moments of the ferroelectric material layer of each of the unit variable-capacitance elements is minimized.

5. The variable-capacitance element according to claim 4, **characterized in that**:

   interelectrode distances of the unit variable-capacitance elements connected in series are the same as each other.

6. A variable-capacitance element, **characterized by** including:

   at least three or more in-plane electrodes stacked with ferroelectric material layers in between;
   a first external electrode formed on the in-plane electrode positioned at the bottom of the stacked in-plane electrodes; and
   a second external electrode formed on the in-plane electrode positioned at the top of the stacked in-plane electrodes.

7. The variable-capacitance element according to claim 6, **characterized in that**:

   in the stacked in-plane electrodes, interelectrode distances between the adj acent in-plane electrodes are the same as each other, and areas of the ferroelectric material layers sandwiched by the adjacent in-plane electrodes are different from each other.

8. A variable-capacitance element, **characterized by** including:

   at least three or more in-plane electrodes stacked with ferroelectric material layers in between;
   a first external electrode formed on the in-plane electrode stacked in an odd-numbered position of the stacked in-plane electrodes; and
   a second external electrode formed on the in-plane electrode stacked in an even-numbered position of the stacked in-plane electrodes.

9. The variable-capacitance element according to claim 8, **characterized in that**:

in the stacked in-plane electrodes, interelectrode distances between the adjacent in-plane electrodes are different from each other, and areas of the ferroelectric material layers sandwiched by the adjacent in-plane electrodes are different from each other.

10. A method for adjusting a variable-capacitance element, the variable-capacitance element including a pair of electrodes formed with a ferroelectric material layer in between, **characterized by** including the steps of:

maximizing or minimizing the sum of electric dipole moments of the ferroelectric material layer; and writing a desired capacitance to the variable-capacitance element by applying a predetermined write voltage between the electrodes of the variable-capacitance element the sum of electric dipole moments of the ferroelectric material layer of which has been maximized or minimized.

11. The method for adjusting a variable-capacitance element according to claim 10, **characterized by** further including the step of:

after applying the predetermined write voltage to write the capacitance, further rewriting the capacitance by applying a different voltage from the previous write voltage.

12. The method for adjusting a variable-capacitance element according to claim 10, **characterized in that**:

the step of minimizing the sum of electric dipole moments of the ferroelectric material layer is performed by heating the ferroelectric material layer to a temperature equal to or higher than the Curie temperature.

13. The method for adjusting a variable-capacitance element according to claim 10, **characterized in that**:

the step of maximizing the sum of electric dipole moments of the ferroelectric material layer is performed by applying between the terminals of the variable-capacitance element a write voltage corresponding to the saturation electric field of the variable-capacitance element.

14. The method for adjusting a variable-capacitance element according to claim 10, **characterized in that**:

the step of minimizing the sum of electric dipole moments of the ferroelectric material layer is performed by applying between the terminals of the variable-capacitance element a write voltage corresponding to the saturation electric field of the variable-capacitance element, and then applying a write voltage that is the coercive voltage with the opposite polarity.

15. A variable-capacitance device, **characterized by** including:

a variable-capacitance element including a pair of electrodes formed with a ferroelectric material layer in between; and
capacitance elements for eliminating dc voltage disposed on both sides of the variable-capacitance element and connected to the variable-capacitance element in series.

16. A variable-capacitance device, **characterized by** including:

a variable-capacitance element in which a plurality of unit variable-capacitance elements are connected in series or parallel, each of the unit variable-capacitance elements including a pair of electrodes formed with a ferroelectric material layer in between; and
capacitance elements for eliminating dc voltage disposed on both sides of the variable-capacitance element and connected to the variable-capacitance element in series.

17. An electronic apparatus, **characterized by** including:

a variable-capacitance device including: a variable-capacitance element including a pair of electrodes formed with a ferroelectric material layer in between; and capacitance elements for eliminating dc voltage disposed on both sides of the variable-capacitance element and connected to the variable-capacitance element in series.

18. An electronic apparatus, **characterized by** including:

a variable-capacitance device including: a variable-capacitance element including a plurality of unit variable-capacitance elements connected in series or parallel, each of the unit variable-capacitance elements including a pair of electrodes formed with a ferroelectric material layer in between; and capacitance elements for eliminating dc voltage disposed on both sides of the variable-capacitance element and connected to the variable-capacitance element in series.

[FIG. 1]

100

V

101

103

102

[FIG. 2]

[FIG. 3]

[FIG. 4]

[FIG. 5]

[FIG. 6]

[FIG. 7]

[FIG. 8]

[FIG. 9]

[FIG. 10A]

5a

8  e1    8  e2    8  e3    8  e4    8  e5  5b

[FIG. 10B]

5a

e1

e2

e3

e4

e5

5b

[FIG. 10C]

10

1c

e2  e1

6                              7

8
t          C1
8
t          C2
8
t          C3
8
t          C4

e5  e4  e3  e2

4c  3c  2c

[FIG. 11]

[FIG. 12A]

[FIG. 12B]

[FIG. 12C]

[FIG. 13]

[FIG. 14]

WRITE VOLTAGE SOURCE

[FIG. 15]

[FIG. 16A]

[FIG. 16B]

[FIG. 16C]

[FIG. 17]

[FIG. 18]

EP 2 249 358 A1

[FIG. 19]

34

## INTERNATIONAL SEARCH REPORT

International application No.

PCT/JP2009/052332

A. CLASSIFICATION OF SUBJECT MATTER
*H01G7/06*(2006.01)i

According to International Patent Classification (IPC) or to both national classification and IPC

B. FIELDS SEARCHED

Minimum documentation searched (classification system followed by classification symbols)
H01G7/06

Documentation searched other than minimum documentation to the extent that such documents are included in the fields searched
| Jitsuyo Shinan Koho | 1922-1996 | Jitsuyo Shinan Toroku Koho | 1996-2009 |
| Kokai Jitsuyo Shinan Koho | 1971-2009 | Toroku Jitsuyo Shinan Koho | 1994-2009 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | WO 95/26570 A1 (Olympus Optical Co., Ltd.),<br>05 October, 1995 (05.10.95),<br>Claims 1, 3, 8, 10, 12, 13; Figs. 5, 11, 12<br>& JP 11-40759 A      & JP 11-39860 A | 1-7<br>9 |
| X<br>Y | JP 2007-235143 A (Sony Corp.),<br>13 September, 2007 (13.09.07),<br>Claims 1, 2; Figs. 2, 3<br>& US 2007/0205449 A1    & SG 135079 A | 8<br>9 |
| X | JP 05-075137 A (Olympus Optical Co., Ltd.),<br>26 March, 1993 (26.03.93),<br>Claims 1, 2; Par. Nos. [0020], [0021], [0035]<br>(Family: none) | 10-14 |

☒ Further documents are listed in the continuation of Box C.    ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>15 May, 2009 (15.05.09) | Date of mailing of the international search report<br>26 May, 2009 (26.05.09) |
|---|---|
| Name and mailing address of the ISA/<br>Japanese Patent Office | Authorized officer |
| Facsimile No. | Telephone No. |

Form PCT/ISA/210 (second sheet) (April 2007)

**INTERNATIONAL SEARCH REPORT**

| International application No. |
|---|
| PCT/JP2009/052332 |

C (Continuation).    DOCUMENTS CONSIDERED TO BE RELEVANT

| Category* | Citation of document, with indication, where appropriate, of the relevant passages | Relevant to claim No. |
|---|---|---|
| X | JP 2005-064437 A  (Kyocera Corp.),<br>10 March, 2005 (10.03.05),<br>Par. Nos. [0002], [0026], [0079], [0081];<br>Figs. 7, 8<br>(Family: none) | 15-18 |

Form PCT/ISA/210 (continuation of second sheet) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007287996 A